# EUROPEAN PATENT APPLICATION

(11) **EP 1 508 946 A1**
(43) Date of publication of application: **23.02.2005**
(21) Application number: 04253073.3
(22) Date of filing: 25.05.2004
(51) Int. Cl.: H01S 5/183, H01L 31/12, H01S 5/026

(54) **Long wavelength vertical cavity surface emitting laser with integrated photodetector**

(30) Priority: 19.08.2003 KR 2003057284
(71) Applicant: Samsung Electronics Co., Ltd., Suwon-city, Gyeonggi-do (KR)
(72) Inventor: Kim, Tak, Jongro-gu Seoul (KR)
(74) Representative: Greene, Simon Kenneth

(57) **Abstract**

A vertical cavity surface emitting laser (VCSEL) integrated with a photodetector is provided. The photodetector is attached to a bottom surface of the VCSEL by a bonding layer, which includes a window of a predetermined diameter. The bonding layer is a eutectic bonding layer. An air gap exists within the window and mainly transmits a laser beam. Most of spontaneous emission light incident at an angle is blocked by an area of the bonding layer other than the window, and even some of the spontaneous emission light that heads toward the window cannot easily passes through the window due to a big difference between refractive indices of a semiconductor layer and the air. Thus, the eutectic bonding layer greatly reduces a voltage drop at an interface between the VCSEL and the photodetector, thereby contributing to mass production.

## Description

The present invention relates to a long wavelength vertical cavity surface emitting laser (VCSEL) with an integrated photodetector.

Generally, a VCSEL diode is combined with a photodetector for power monitoring and automatic power control (APC) based on the power monitoring. For example, in U.S. Patent No. 5,943,357, a photodetector is attached to a long wavelength VCSEL by wafer fusion.

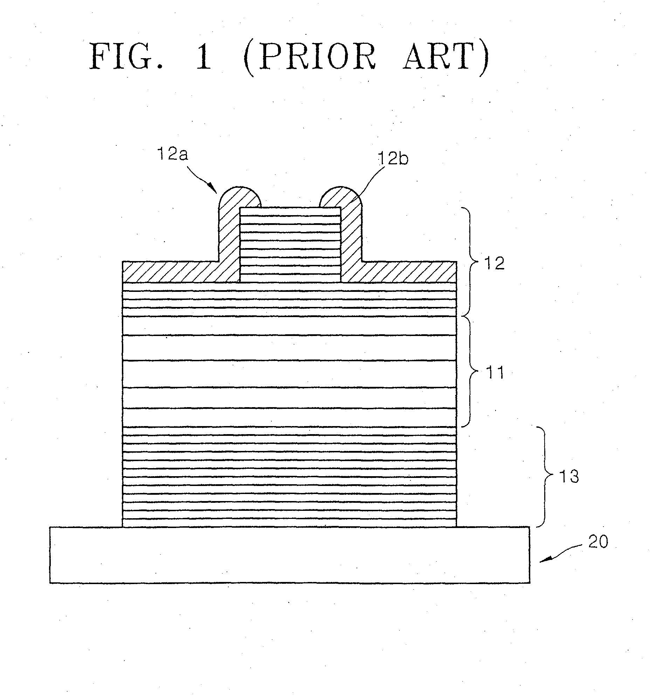

FIG. 1 is a simplified cross-section of a conventional VCSEL to which a photodetector is fused. Referring to FIG. 1, the conventional VCSEL includes an upper semiconductor layer 12 of distributed Bragg reflectors (DBR), an active region 11, and a lower semiconductor layer 13 of DBRs, which are sequentially deposited on a substrate (not shown). The active region 11 is a cavity where central laser resonance occurs. A PIN photodetector 20 is fused or bonded to a bottom of the VCSEL having such a configuration.

As described above, a photodetector, for example, a PIN photodetector, is attached to a bottom of a long-wavelength VCSEL (e.g., a long wavelength of 1300 to 1600nm) and monitors the power output of the VCSEL. Typically, the attaching technique may be a wafer bonding, a wafer fusion, or a transparent metal adhesion.

Wafer fusion is not suitable for mass-production because of process-related problems. Also, wafer fusion causes a voltage drop at the interface between a photodetector and a VCSEL. As a result, the amount of input voltage must be increased.

A disadvantage of the conventional VCSEL is that a photodetector cannot accurately detect only the output of the VCSEL because the photodetector receives both spontaneous emission and a beam emitted from the VCSEL.

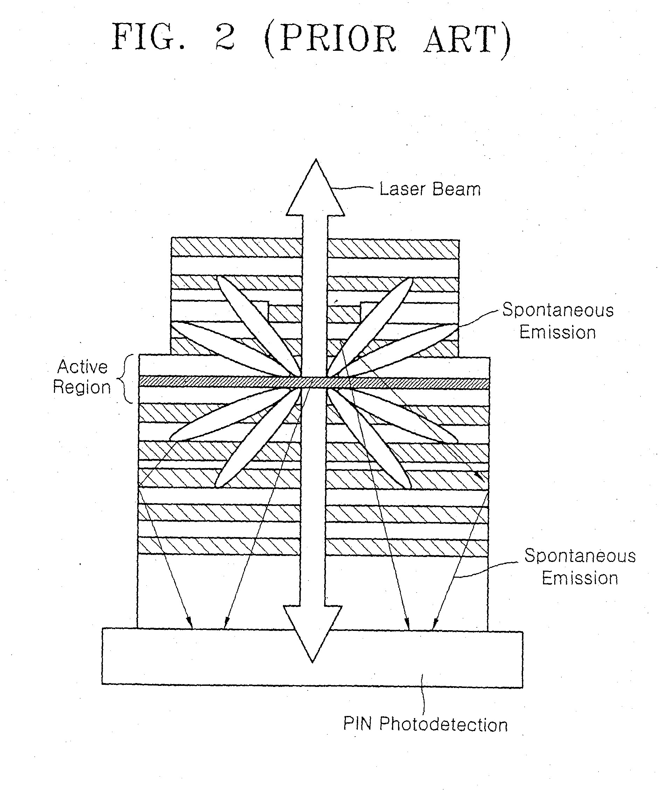

Referring to FIG. 2, both light generated from spontaneous emission and a laser beam emitted from an active region of a conventional VCSEL are introduced into regions other than the active region. Since the structure of the VCSEL is substantially the same as that of a resonant cavity light emitting diode (LED); the spontaneous emission is directed in all directions.

When a VCSEL is designed so that a beam heading for an upper part of the VCSEL can be used as an output, DBRs of a lower semiconductor layer of the VCSEL have higher refractive indices than those of an upper semiconductor layer thereof. Accordingly, the intensity of a laser beam heading for a lower part of the VCSEL is relatively lower than that of the beam heading for the upper part of the VCSEL. Because a laser beam with a diameter of about 10 µm is typically emitted from a VCSEL, and spontaneous emission is directed in all direction, the intensity of the laser beam is higher than that of the spontaneous emission at a specific area of a photodetector where the laser beam passes (i.e., at an area with an approximately 10 µm diameter located directly down a center of the VCSEL). However, the percentage of spontaneous emission received by the entire area of the photodetector is quite high. Particularly, this feature appears in the VCSEL shown in FIGS. 1 and 2, to a bottom surface of which a light-receiving surface with an about 200-300 µm width of the photodetector 20 is bonded so as to receive light from the VCSEL.

The present invention provides a vertical cavity surface emitting layer (VCSEL) which can more accurately detect a laser beam by reducing the amount of spontaneous emission incident upon a photodetector and increasing the percentage of spontaneous emission incident upon the photodetector.

Also, the VCSEL can lower the amount of input voltage by reducing a voltage drop at an interface between the VDSEL and a photodetector.

The VCSEL comprises a lasing structure, which includes an active region which emits a laser beam and upper and lower semiconductor layer between which the active region is sandwiched, a photodetector, which is disposed on a bottom surface of the lasing structure, and a conductive bonding layer, which is disposed between the lasing structure and the photodetector and includes a partial window through which the laser beam from the active region passes.

The above and other features and advantages of the present invention will become more apparent by describing in detail exemplary embodiments thereof with reference to the attached drawings in which:
FIG. 1 is a simplified vertical cross-section of a conventional vertical cavity surface emitting laser (VCSEL) with a photodetector;
FIG. 2 illustrates a flow of a laser beam and spontaneous emission from a conventional VCSEL to a photodetector;
FIG. 3 is a simplified vertical cross-section of a vertical cavity surface emitting laser (VCSEL) with a photodetector according to an exemplary embodiment of the present invention;
FIG. 4 is a top view of a bonding layer used by the VCSEL of FIG. 3; and
FIG. 5 illustrates a flow of a laser beam and spontaneous emission from the VCSEL of FIG. 3 to the photodetector of FIG. 3.

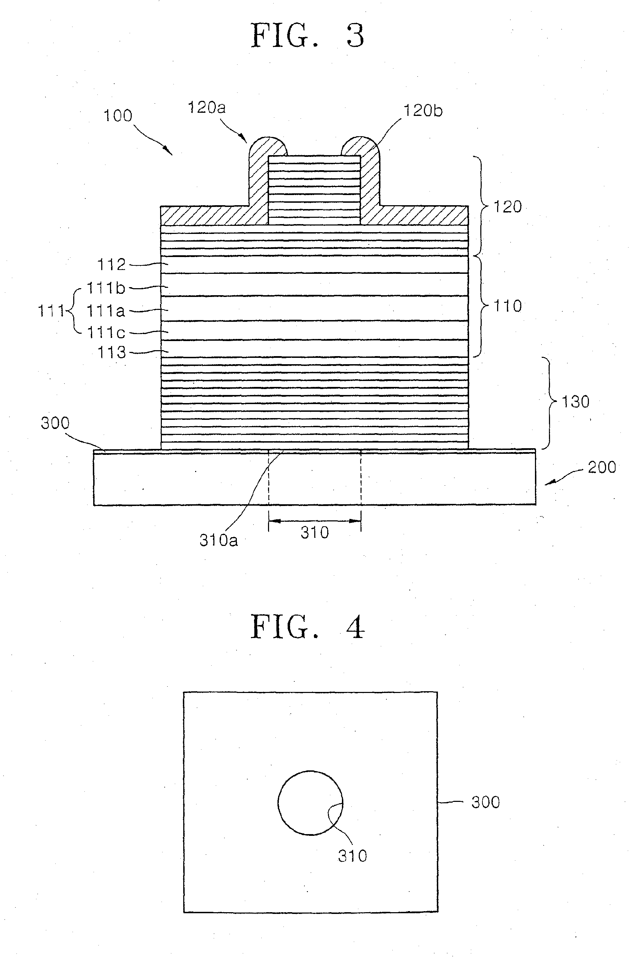

FIG. 3 schematically illustrates a vertical cavity surface emitting laser (VCSEL) in which a ridge is formed on an upper semiconductor layer. The VCSEL is a well-known lasing structure which includes an active region where lasing occurs and upper and lower semiconductor layers between which the active region is sandwiched. Hence, the following detailed description of the lasing structure does not limit the technical scope of the present invention.

As shown in FIG. 3, a lasing structure 100 includes an active region 110, which is a cavity where laser resonance occurs, and upper and lower semiconductor layers 120 and 130 of distributed Bragg reflectors (DBR), between which the active region 110 is sandwiched. The lower semiconductor layer 130 includes a substrate (not shown). The active region 110 includes an active layer 111 and cladding layers 112 and 113 between which the active layer 111 is sandwiched. The active layer 111 includes a quantum well layer 111a and barrier layers 111b and 111c, between which the quantum well layer 111a is sandwiched. The upper semiconductor layer 120 corresponds to an upper mirror stack and includes the ridge 120a. The lower semiconductor layer 130 corresponds to a lower mirror stack and faces a photodetector 200. An upper contact layer 120b covers an area that excludes a top surface of the ridge 120a but includes an edge of the top surface thereof.

As in a conventional technique, the photodetector 200 is attached to a bottom surface of the lasing structure 100. According to a feature of the present invention, the photodetector 200 and the lasing structure 100 are bonded by a bonding layer 300. The bonding layer 300 includes a window 310, which has a width corresponding to the diameter of a laser beam, and has a predetermined thickness. Hence, an air gap exists between the photodetector 200 and the window 310 of the lasing structure 100, that is, between the photodetector 200 and the VCSEL. The air gap transmits a laser beam that is emitted from the active region 110 and vertically incident upon the air gap. Also, the air gap reflects aslant incident light of spontaneous emission so that the spontaneous emission light cannot be incident upon the photodetector 200.

The bonding layer 300 inevitably includes the window 310 and preferably adopts metal bonding and eutectic bonding. Alternatively, the bonding layer 300 may adopt general adhesion. Although the photodetector 200 is extremely simply illustrated for the sake of convenience, its structure is well known and does not limit the technical scope of the present invention.

As shown in FIG. 4, the bonding layer 300 has a circular window 310, through which a laser beam emitted from the lasing structure 100 passes, at a center of the bonding layer 300. The size and shape of the window 310 may vary according to design conditions.

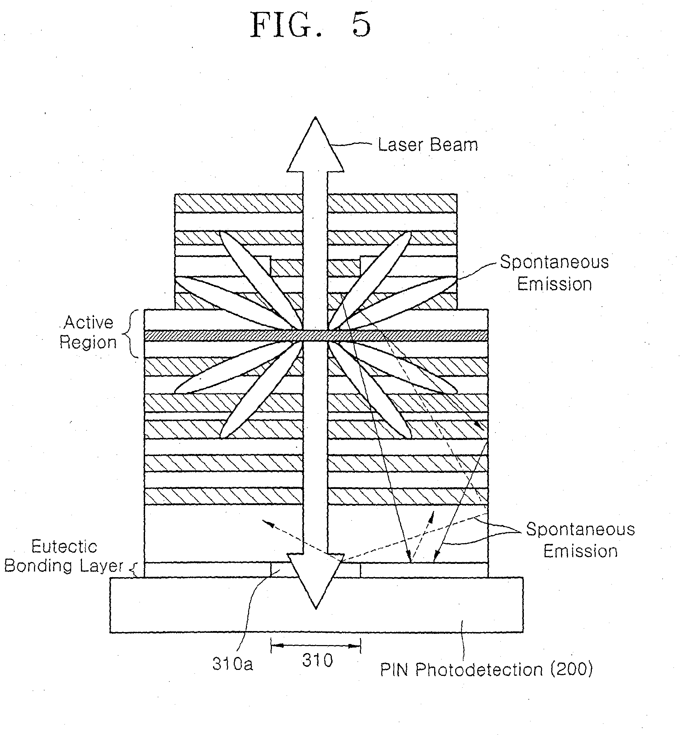

As described above, a lasing structure (i.e., a VCSEL) according to the present invention is bonded to a photodetector (e.g., a PIN photodetector) by a bonding layer to which metal bonding, which suitable for mass production, is applied. Particularly, metal bonding greatly decreases a voltage drop at an interface between the VCSEL and the photodetector. The bonding layer includes a window for transmitting only a laser beam used to monitor the power output of the VCSEL while screening light of spontaneous emission. Hence, as shown in FIG. 5, only light passed through the window 310 is incident upon the photodetector 200 because the window 310 is disposed in a path along which the laser beam emitted from the VCSEL mainly travels, more specifically, on an axis where the laser beam travels in a vertical direction with respect to the VCSEL. Even if some spontaneous emission lights vertically passes through the window 310 of the bonding layer 300, many are blocked by an area of the bonding layer 300 other than the window 310. In practice, the percentage of spontaneous emission light incident upon the photodetector 200 is extremely smaller than that of the laser beam, and accordingly, the laser beam can be more precisely monitored.

Preferably, the diameter of the window is in the range of 1 to 100 µm. In the bonding layer which bonds the VCSEL and the photodetector, an air gap is formed within the window between the VCSEL and the photodetector. The air gap serves as a light filter based on a big difference between the refractive indices of a semiconductor layer and an air layer. Hence, the window reflects spontaneous emission light incident at an angle, thereby reducing the amount of spontaneous emission light incident upon the photodetector.

Metal bonding, particularly, eutectic bonding, may be either wafer-level bonding, for example, bonding between a non-isolated VCSEL wafer and a non-isolated photodetector wafer, or chip-level bonding, for example, bonding between an isolated VCSEL chip and an isolated photodetector chip.

The bonding layer adopting metal bonding or eutectic bonding may be used as a lower electrode (e.g., an n-type electrode) of the VCSEL or an electrode at one side of the photodetector.

The present invention relates to a device fabricated by bonding a VCSEL and a photodiode (i.e., a photodetector) using the above-described techniques. These bonding techniques are applied without being restricted by the structure of a particular VCSEL or the type of photodetector.

For example, these bonding techniques are applied to a structure in which a VCSEL fabricated by sequentially stacking a lower semiconductor layer of DBRs, a resonance region (i.e., an active region) having an active layer, and an upper semiconductor layer of DBRs on a substrate is bonded to a photodiode for monitoring the intensity of a laser beam emitted from the VCSEL by forming a metallic bonding layer with a window on a bottom surface of the substrate. Preferably, the window is located on an axis where the laser beam of the VCSEL travels.

The photodetector supporting the VCSEL serves as a submount which supports a whole structure. In the VCSEL, the substrate is formed of gallium arsenide (GaAs), and the active layer is formed of one of an indium gallium arsenide (InGaAs) quantum well, an indium gallium arsenide nitride (InGaAsN) quantum well, and an In(Ga)(N)As quantum dot.

Even if the bonding layer serves as a general adhesion instead of a eutectic bonding layer, the bonding layer can produce the above-described optical effect as long as it includes such a window.

If the bonding layer is a eutectic bonding layer, it can reduce a voltage drop at an interface between the VCSEL and the photodetector, contributing to mass production.

An advantage of the present invention is that, as fully described above, a bonding layer serves not only as a means for bonding a VCSEL and a photodetector but also as a means for blocking unnecessary light. Furthermore, if a eutectic bonding layer is used as the bonding layer, a VCSEL having optical characteristics as described above can be mass-produced.

The VCSEL-photodetector structure of the present invention is applicable to various fields, such as, an optical recording/reproducing apparatus, an optical scanner, and the like which use a laser beam.

While the present invention has been particularly shown and described with reference to exemplary embodiments thereof, it will be understood by those of ordinary skill in the art that various changes in form and details may be made therein without departing from the scope of the present invention as defined by the following claims.

## Claims

1. A vertical cavity surface emitting laser comprising:
a lasing structure, which includes an active region which emits a laser beam and upper and lower semiconductor layer between which the active region is sandwiched;
a photodetector, which is disposed on a bottom surface of the lasing structure; and
a conductive bonding layer, which is disposed between the lasing structure and the photodetector and includes a partial window through which the laser beam from the active region passes.

2. The vertical cavity surface emitting laser of claim 1, wherein the conductive bonding layer is a eutectic bonding layer.

3. The vertical cavity surface emitting laser of claim 1 or 2, wherein an air gap exists within the window between the lasing structure and the photodetector.

4. The vertical cavity surface emitting laser of any preceding claim, wherein the window is located on an axis along which the laser beam generated by the lasing structure travels.

5. The vertical cavity surface emitting laser of any preceding claim, wherein the photodetector serves as a submount which supports the lasing structure.

6. The vertical cavity surface emitting laser of any preceding claim, wherein the lower semiconductor layer includes a substrate.

7. The vertical cavity surface emitting laser of claim 6, wherein the substrate is made of gallium arsenide (GaAs), and the active region is made of one selected from the group consisting of an indium GaAs (InGaAs) quantum well, an InGaAlN quantum well, and an In(Ga)(N)As quantum dot.

8. The vertical cavity surface emitting laser of claim 6, wherein the substrate is made of indium phosphide (InP), and the active region is made of one selected from the group consisting of an InGaAsP quantum well, an indium gallium aluminium arsenide (InGaAlAs) quantum well, an In(Ga)(N)As quantum dot, and an aluminium gallium arsenide stibium (AIGaAsSb) quantum well.
